# EUROPEAN PATENT APPLICATION

(11) **EP 1 858 306 A1**
(43) Date of publication of application: **21.11.2007**
(21) Application number: 06712248.1
(22) Date of filing: 24.01.2006
(51) Int. Cl.: H05K 1/02, H05K 1/18, H01B 7/08

(54) **THREE-DIMENSIONAL WIRING BODY FOR MOUNTING ELECTRONIC COMPONENT AND ELECTRONIC COMPONENT MOUNTING STRUCTURE**

(30) Priority: 25.01.2005 JP 2005016379
(71) Applicant: The Furukawa Electric Co., Ltd., Chiyoda-ku Tokyo 100-8322 (JP)
(72) Inventor: ENOMOTO, Noritsugu, hi 2-chome, Chiyoda-ku Tokyo, 1008322 (JP); UTSUNOMIYA, Hirofumi, hi 2-chome, Chiyoda-ku Tokyo, 1008322 (JP); KAMIMURA, Ken, hi 2-chome, Chiyoda-ku Tokyo, 1008322 (JP); MOTOMURA, Shigeki, hi 2-chome, Chiyoda-ku Tokyo, 1008322 (JP); AOYAGI, Shigeharu, hi 2-chome, Chiyoda-ku Tokyo, 1008322 (JP); TAKEDA, Junichi, hi 2-chome, Chiyoda-ku Tokyo, 1008322 (JP)
(74) Representative: Zech, Stefan Markus
(86) International application number: PCT/JP2006/301032
(87) International publication number: WO 2006/080301

(57) **Abstract**

An electronic components mounted wiring body (10) comprises a flat wiring body (2) on which a plurality of electronic components (20) is mounted, and a plurality of base members (31) on which the flat wiring body (2) is mounted. The flat wiring body (2) has arrangement direction changing folds (9), each of which is designed to change an arrangement direction of the electronic components (20) of the flat wiring body (2). Each base member (31) has an arrangement direction changing member (37) which is designed to fix the arrangement direction changing fold (9). The base members (31) are joined using joining members (32) so that the electronic components mounted wiring body (10) is configured into a three-dimensional shaped electronic components mounting structure (1).

## Description

### Technical Field

The present invention relates to an electronic components mounted wiring body for use in vehicles and others as well as an electronic components mounting structure.

### Background Art

In recent years, light emitting diodes (LEDs) have been widely used for lamps on the front and rear of automobiles. An Electric wire, bus bar or flat wiring body has been used to form a wiring circuit or power feed circuit for such LEDs. For instance, a light emitting structure in which LEDs that are connected to electric wires are arranged in three dimensional steps is known (see patent documents D1 and D2). Also known is another light emitting structure in which LEDs that are connected to a flat wiring body are arranged in a three dimensional steps (see patent documents D3 to D6).
Patent Document D1: Japanese Patent Application Publication 2000-243110
Patent Document D2: Japanese Patent Application Publication 2002-245812
Paten Document D3: Japanese Patent Application Publication H10-247421
Paten Document D4: Japanese Patent Application Publication 2001-222915
Paten Document D5: Japanese Patent Application Publication 2002-133917
Paten Document D6: Japanese Patent Application Publication 2004-247281

### Summary of the Invention

### Problem to be solved

However, the above mentioned conventional art disclosed in the respective patent documents generally has two problems: The first problem is associated with the operability of the mounting and assembling. In the case of patent documents D1 and D2, the light emitting structure using a wiring circuit in the form of electric wires or bus bars requires time-consuming and troublesome operations for mounting and wiring LEDs on a complicated and integrally formed, three-dimensional base of the structure. Similarly in the case of patent documents D3 to D6, the light emitting structure using a flat wiring body requires time-consuming and troublesome operations for positioning LEDs at respective steps and fixing the flat wiring body. Thus in either case, the mounting cost is increased accordingly.

The second problem is associated with the cost of parts and material. Specifically, the art disclosed in patent documents D1 to D6 uses an integrally fixed base for arranging a plurality of LEDs. Such a base generally serves as the one specialized for an individual particular light emitting structure. Hence, in order for the base to address various kind of the light emitting structure, increased kinds of such bases are required, thus increasing the material and management cost. In addition, the volume of the base tends to be increased for the mounting capability requirement so that the freedom of designing the base is limited. Furthermore, in the case of the patent documents D3 to D6, which use a straight flat wiring body, it is difficult to arrange the light emitting devices in a curved line (e.g. circular arc) in order to correspond to the shape of the light emitting structure, thus requiring a specialized pattern circuit and increasing the material cost.

Therefore, it is an object of the present invention to provide an electronic components-mounted wiring body with which mounting operations on the structure can easily and surely be done even when a complicated wiring pattern is required, and the mounting cost and the material cost are thus reduced.

### Solution

According to the present invention, a first embodiment of the electronic components mounted wiring body comprises a flat wiring body on which a plurality of electronic components is mounted, and a plurality of base members on which the flat wiring body is mounted, wherein the flat wiring body includes arrangement direction changing folds which are bent so as to change an arrangement direction of the electronic components, and wherein the base members include arrangement direction changing members which fix the arrangement direction changing folds.

In a second embodiment of the electronic components mounted wiring body, the base members are identical in shape.

In a third embodiment of the electronic components mounted wiring body, the flat wiring body is preformed with fold lines at which the flat wiring body is bent afterward to form bends.

In a fourth embodiment of the electronic components mounted wiring body, the electronic components comprise light emitting diodes.

In a fifth embodiment of the electronic components mounted wiring body, a pierce terminal and a feed line are connected to the flat wiring body at a portion thereof so that the piece terminal mechanically and electrically connects the flat wiring body to the feed line.

In a sixth embodiment of the electronic components mounted wiring body, connectors each having a rear plate and a piercing member are provided to electrically and mechanically connect the electronic components to the flat wiring body.

In a seventh embodiment of the electronic components mounted wiring body, leads of the electronic component are connected to the rear plate of the connector by means of shear connection.

In an eighth embodiment of the electronic components mounted wiring body, the base members are formed with holes at appropriate positions thereof to fix or expose the electronic components.

In a ninth embodiment of the electronic components mounted wiring body, the base members include fixing structures which fix the flat wiring body to the base members.

According to the invention, a tenth embodiment of the electronic components mounted wiring body comprises a flat wiring body on which a plurality of electronic components is mounted, and a plurality of base members on which the flat wiring body is mounted, wherein the flat wiring body includes arrangement direction changing folds which are bent so as to change an arrangement direction of the electronic components, wherein the base members include arrangement direction changing members which fix the arrangement direction changing bends, and wherein joining members are used to join the plurality of the base members to configure the electronic components mounted wiring body into a three-dimensional shape.

### Advantage of the invention

The present invention provides an electronic components mounted wiring body which comprises a flat wiring body on which a plurality of electronic components is mounted, and a plurality of base members on which the flat wiring body is mounted, wherein the flat wiring body includes arrangement direction changing folds which are bent so as to change an arrangement direction of the electronic components, and wherein the base members include arrangement direction changing members which fix the arrangement direction changing folds. Thus, the present invention reduces the time-consuming operations that are required in the conventional art to individually mount and wire electronic components on the base structure at respective positions which is integrally formed in a complicated three dimension. In addition, unlike the conventional art, there is no need for preparing a variety of base structures according to product kinds. The present invention can be adapted to different product kinds by simply combining and assembling a reduced set of standard base members, thus increasing the freedom of design.

According to the present invention, the electronic components mounting structure uses the base members which are identical in shape. Hence, unlike the conventional art, there is no need for preparing various kinds of base structures according to product kinds, and thus the component cost and the management cost are significantly reduced.

In addition, according to the present invention, the base members of the electronic components mounting structure include arrangement direction changing folds which are bent so as to change an arrangement direction of the electronic components. Hence, a curved arrangement of electronic components, which has been difficult for the conventional flat wiring body to make, can be realized by a simple operation and at low cost so that the mounting cost and the material cost is reduced.

Further, according to the invention, the electronic components mounted wiring structure uses joining members to join the plurality of the base members to configure the electronic components mounted wiring body into a three-dimensional shape. Hence, a variety of electronic components mounted wiring structures having different shapes can be provided at a low cost.

### Brief Description of the Drawings

FIG. 1 is a plan view of an electronic components mounted wiring body according to an embodiment of the present invention;
FIG. 2 is a rear perspective view showing the flat wiring body and one of the base members in FIG. 1, as viewed from the rear;
FIG. 3 is a plan view of the flat wiring body;
FIG. 4 is a plan view showing an embodiment in which a base member having an arrangement direction changing member is mounted to the flat wiring body;
FIG. 5 is a plan view showing another embodiment in which a base member having the arrangement direction changing member is mounted to the flat wiring body;
FIG. 6 is a plan view showing a still another embodiment in which a base member having the arrangement direction changing member is mounted to the flat wiring body;
FIG. 7 is a rear perspective view of an electronic components mounting structure, as viewed from the rear according to the embodiment of the invention;
FIG. 8 is a perspective view showing an electronic component with connectors;
FIG. 9 is a partial section view illustrating how the electronic component and connectors is mounted on the flat wiring body;
FIG. 10 is a perspective view showing a feed line and a pierce terminal;
FIG. 11 is a side view of the flat wiring body; and
FIG. 12 is a plan view of the flat wiring body.

### Description of Reference Symbols

1: electronic components mounting structure
2: flat wiring body
3: flat conductor
4: insulating coating
5: bend
6: feed line
6a: conductor
6b: insulating coating
7: pierce terminal
7a: rear plate
7b: piercing member
7c: insulation barrel
7d: crimping barrel
8: circuit separator
9: arrangement direction changing fold
9a: mountain fold
9b: valley fold
10: electronic components mounted wiring body
20: electronic component
21: light emitting device
22: lead
23: connector
23a: back plate
23b: piercing member
23c: shear
30: base structure
31, 31a, 31b, 31c: base member
32: joining member
33: hole
34: slit
34a: cutout
35: locking piece
36: fitting protrusion
37: arrangement direction changing member
40: reflector
41: inserting hole
42: protrusion
50: fold line

### Best Modes for Carrying out the Invention

The present invention will now be described with respect to an embodiment thereof taken in conjunction with the drawings.

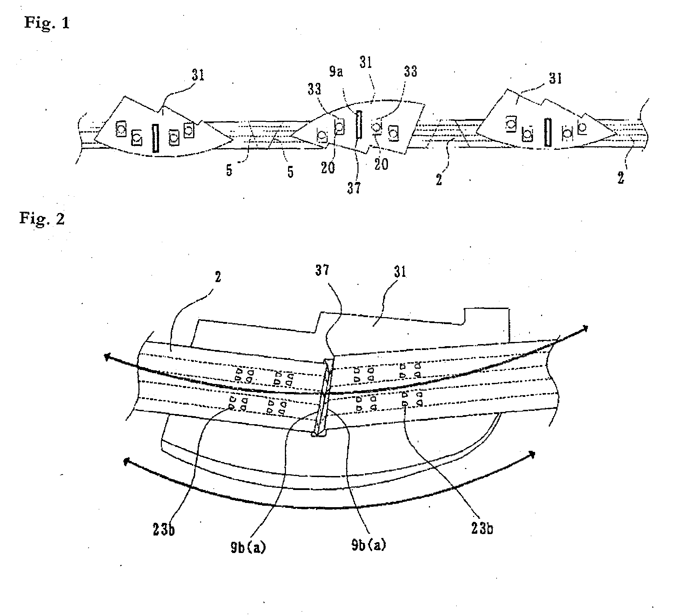

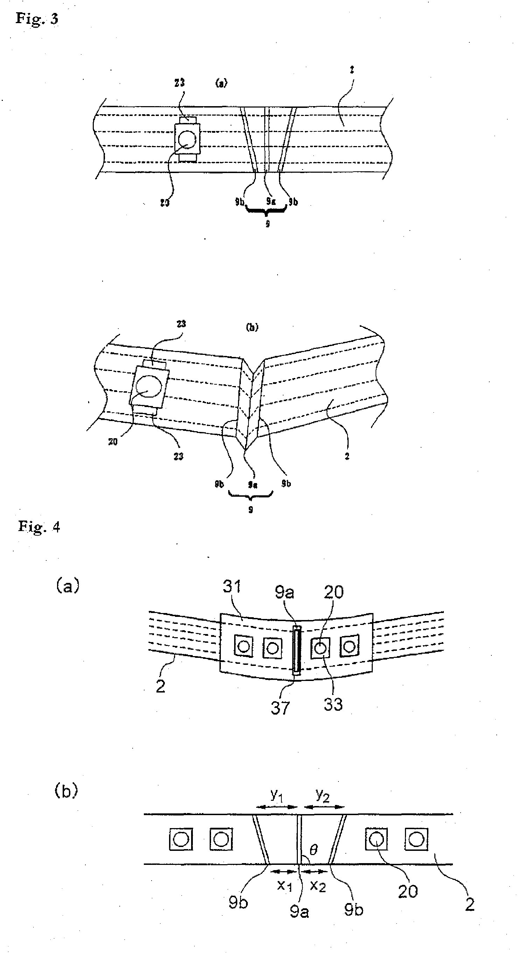

FIGs. 1 to 3 show an electronic components mounted wiring body according to the embodiment of the present invention. Specifically, FIG. 1 is a plan view showing base members 31 mounted to a flat wiring body 2. FIG. 2 is a rear perspective view showing the flat wiring body 2 and one of the base members 31 in FIG. 1, as viewed from the rear. FIG. 3 is a plan view of the flat wiring body 2.

In the embodiment of the invention, the electronic component mounted wiring body is assembled by mounting a plurality of the base members 31 to the flat wiring body 2, on which a plurality of electronic components 20 is mounted. According to a feature of the present invention, each base member 31 has an arrangement direction changing member 37 to change the arrangement direction of the electronic components 20 of the flat wiring body 2. This feature will be described in more detail in the following.

As shown in FIG. 1, each base member 31 has holes 33 formed therein in which electronic components 20 are positioned. The arrangement of the holes 33 of the base member 31 may be formed in a variety of ways depending on particular product types, including a linear arrangement, a circular arc arrangement, an L arrangement, an S arrangement etc. In the illustrated example of FIG. 1, these holes 33 are arranged in a circular arc. To adapt the linear flat wiring body 2 to the base members 31 with the holes 33 arranged in this variety of ways, each base member 31 has the arrangement direction changing member 37 formed therein so that the arrangement direction of the electronic components 20 of the flat wiring body 2 is accordingly changed at the position of the arrangement direction changing member 37. Each base member 31 may be made of hard plastic material such as polybutylene terephthalate (PBT) or metal material such as aluminum alloy.

Changing the arrangement direction of electronic components 20 is realized by fitting or inserting one of arrangement direction changing folds 9 of the flat wiring body 2 into the arrangement direction changing member 37 in the form of a hole formed in each base member 31, as indicated in FIG. 2. Each arrangement direction changing fold 9 formed in the flat wiring body 2 is comprised of a mountain fold 9a and valley folds 9b, as shown in FIG. 3 (a), and is bent or folded in the manner shown in FIG. 3 (b) to cause the flat wiring body 2 to be angled thereat. The arrangement direction changing fold 9 formed in this way is fit into the arrangement direction changing member 37 of a base member 31 by inserting the mountain fold or ridge 9a into the member 37 in order that the flat wiring body 2 can be adapted to any base member 31 even with its holes 33 arranged in a non-linear array.

FIG. 4 is a plan view showing an embodiment in which a base member 31 having the arrangement direction changing member 37 is mounted to the flat wiring body. As shown in FIG. 4(a), electronic components 20 are mounted on the flat wiring body 2, which is in turn mounted on the base member 31. In some cases, it is desired that the electronic components 20 such as LEDs be arranged in a curve. The arrangement direction changing member 37, which may take the form of a hole as stated above, is provided at or near the center of the base member 31 as shown in FIG. 4(a).

The direction of the flat wiring body 2 is changed by fitting its arrangement direction changing fold 9 into the arrangement direction changing member 37. If desired, the number of the base members 31 could be one. In the embodiment illustrated in FIG. 4(a), only one arrangement direction changing member 37 is shown, but a plurality of such arrangement direction changing members 37 may be provided in a single base member 31. In the latter arrangement, for example, two LEDs may be arranged between two adjacent members of the arrangement direction changing members 31 in such a manner that, as a whole, a plurality of LEDs is arranged in a desired curve. It may be preferred that the number of LEDs arranged between one end and the arrangement direction changing member 37 of the base member 31 is at most two.

In FIG. 4(b), the flat wiring body 2 is shown having an arrangement direction changing fold 9 which is composed of a mountain fold 9a and valley folds 9b. With this arrangement direction changing fold 9 fixed in the arrangement direction changing member 37 of a base member 31, the flat wiring body 2 is arranged with a desired angle.

It should be noted in FIG. 4(b) that the distances between the mountain fold 9a and the valley folds 9b at both side edges of the flat wiring body 2 and the angle formed between the mountain fold 9a and the side edges may be chosen to set any desired arrangement direction of the electronic components 20.

For example, the angle θ formed between the side edges of the flat wiring body 2 and the mountain fold 9a is set to a right angle. The distances x1, x2, y1 and y2 between the mountain fold 9a and the valley folds 9b at the side edges are set so as to meet the relations of x1=x2, y1=y2, x1≠y1 and x2≠y2. With these settings, the arrangement direction of the electronic components 20 of the flat wiring body 2 is changed at the position of the arrangement direction changing fold 9 with respect to the angle of the arrangement direction while sections of the flat wiring body 2 extending from opposite sides the arrangement direction changing fold 9 are kept generally flat. The amount of the changing angle of the arrangement direction may be adjusted by values of the distances x1, x2, y1 and y2 between the mountain fold 9a and the valley folds 9b.

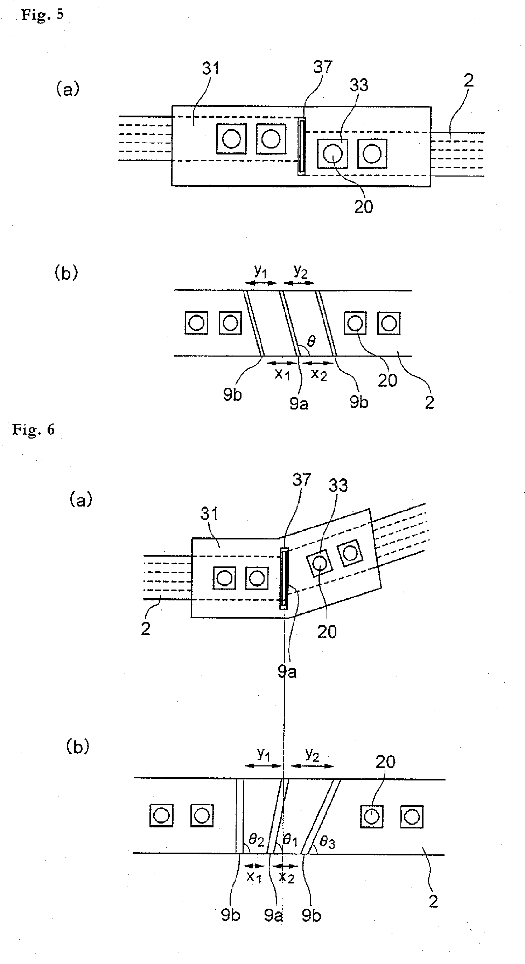

FIG. 5 is a plan view showing another embodiment in which a base member 31 having the arrangement direction changing member 37 is shown mounted to a flat wiring body 2. According to this embodiment, the flat wiring body 2 undergoes a lateral shift at the arrangement direction changing member 37 with respect to the longitudinal direction thereof, as shown in FIG. 5(a). Thus, the electronic components 20, which are longitudinally arranged on the flat wiring body 2, are also laterally shifted at the position of the arrangement direction changing member 37 with respect to the arrangement direction thereof.

In FIG. 5(b), the flat wiring body 2 is shown having an arrangement direction changing fold 9 which is composed of a mountain fold 9a and valley folds 9b. This arrangement direction changing fold 9 is designed to cause the flat wiring body 2 to be laterally shifted with respect to the arrangement direction thereof. The amount of the lateral shift may be adjusted by values of the distances between the mountain fold 9a and the valley folds 9b.

For example, the angle θ formed between the side edges of the flat wiring body 2 and the mountain fold 9a is set to an acute angle of 0<θ<90 degrees or obtuse angle of 90<θ<180 degrees. The distances x1, x2, y1 and y2 between the mountain fold 9a and the valley folds 9b at the side edges of the flat wiring body 2 are set so as to meet the relations of x1=x2, y1=y2, x1=y1 and x2=y2. With these settings, the arrangement direction of the electronic components 20 of the flat wiring body 2 is laterally shifted at the position of the arrangement direction changing fold 9 while sections of the flat wiring body 2 extending from opposite sides the arrangement direction changing fold 9 are kept generally flat.

FIG. 6 is a plan view showing a still another embodiment in which a base member 31 having the arrangement direction changing member 37 is shown mounted to a flat wiring body 2. This embodiment is a combination of the embodiments described in conjunction with FIGs. 4 and 5. As shown in FIG. 6(a), the flat wiring body 2 undergoes both an angular change and a lateral shift at the arrangement direction changing member 37 with respect to the longitudinal direction thereof.

In FIG. 6(b), the flat wiring body 2 is shown having an arrangement direction changing fold 9 which is composed of a mountain fold 9a and valley folds 9b. This arrangement direction changing fold 9 is designed to cause the flat wiring body 2 to be angularly changed with respect to the arrangement direction thereof and at the same time laterally shifted with respect to the longitudinal direction thereof.

For example, the angle θ1 formed between the side edges of the flat wiring body 2 and the mountain fold 9a is an acute angle of 0<θ1<90 degrees or obtuse angle of 90<θ1<180 degrees. The angleθ2 formed between the side edges of the flat wiring body 2 and the left valley fold 9b is 0<θ2<180 degrees. The angleθ3 formed between the side edges and the right valley fold 9b is 0<θ3<180 degrees. These anglesθ1, θ2, andθ3 are set so as to meet the relation of (θ2-θ1)=(θ1-θ3). With these settings, the arrangement direction of the electronic components 20 of the flat wiring body 2 is angularly changed and laterally shifted at the position of the arrangement direction changing fold 9 while sections of the flat wiring body 2 extending from opposite sides the arrangement direction changing fold 9 are kept generally flat. The distances x1, x2, y1 and y2 between the mountain fold 9a and the valley folds 9b at the side edges of the flat wiring body 2 may be represented by a function of angles θ1, θ2, θ3. The right angle for θ1(θ1=90 degrees) is excluded from this arrangement since the right angle of θ1 would produce the same result as the embodiment of FIG. 4

The invention has been described with respect to particular embodiments of the electronic components mounted wiring body, which can be assembled into an electronic components mounting structure in the manner as described in the following.

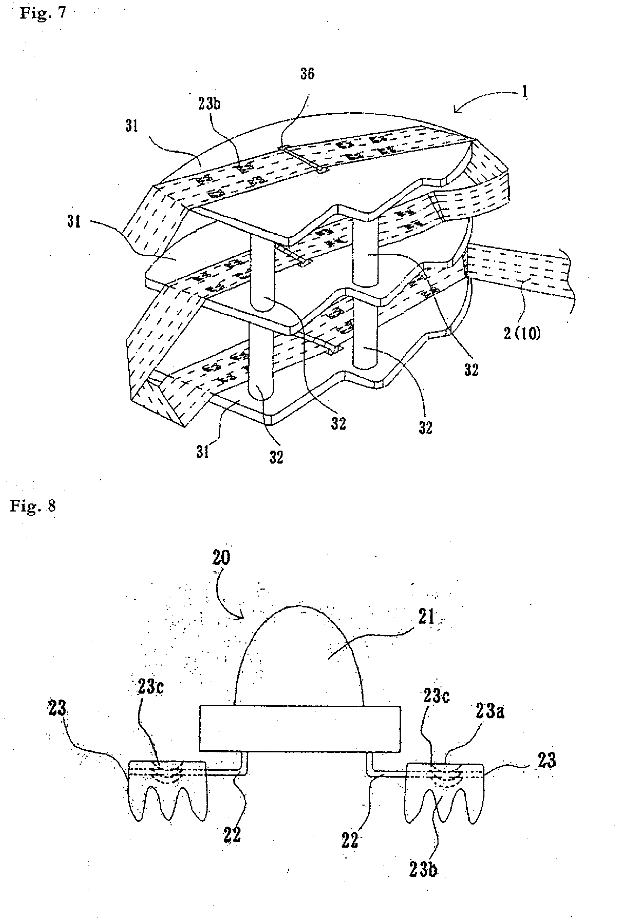

The electronic components mounting structure is assembled as follows. First, the electronic components 20 are mounted on the flat wiring body 2, as shown in FIGs. 2 and 3. Next, a plurality of base members 31 is mounted to the flat wiring body 2, as shown in FIG. 1 to construct an electronic components mounted wiring body. Then, the electronic components mounted wiring body is bent at positions of bends 5 while the base members 31 are joined by joining members 32. As a result, an electronic components mounting structure 1 such as the one shown in FIG. 7 is constructed. This assembling method can easily be adapted to automated production systems and contribute to further cost reduction. The base members 31 may include fixing structures (not shown) through which the bends 5 of the electronic components mounted wiring body 10 or straight portions thereof are inserted. For instance, the fixing structures each may take the form of a cantilever or locking claws.

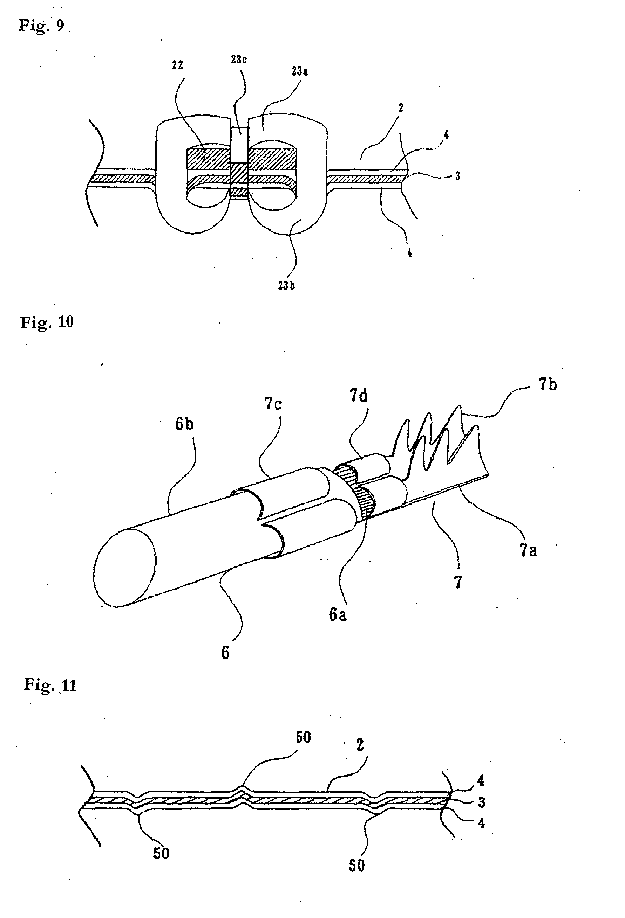

The flat wiring body 2, electronic components 20 and their connection will now be described. The electronic components 20 mounted on the flat wiring body 2 may comprise light emitting devices 21 such as LEDs each having two leads 22 as shown in FIG. 8. In the illustrated embodiment, each lead 22 is bent in an L-shape plate. The flat wiring body 2 is comprised of a plurality of parallel flat conductors 3, as shown in FIG. 9, which are coated with an insulating coating 4 by gluing or extrusion coating a plastic film (e.g. polyethylene terephthalate film). The flat conductor 3 may be made of a copper tape having thickness of 0.15 mm and width of 5.2 mm, for example.

The electronic component 20 is electrically and mechanically connected to the flat wiring body 2 by a connector 23. As shown in FIG. 8, the connector 23 may be comprised of a back plate 23a and a piercing member 23b which is formed below (as seen in FIG. 4) the back plate 23a from both sides thereof. The connector 23 may be made from one metal plate by punching and bending it. The distance between the piercing members 23b of the opposite connectors 23 is chosen such that the leads 22 of the electronic component 20 fit therebetween. The leads 22 of the electronic component 20 are respectively positioned at the flat conductors 33 without stripping the insulating coating 4 from the flat wiring body 2.

Each connector 23 is set such that the piercing member 23b is positioned on both sides of the lead 22. The piercing member 23b pierces through a flat conductor 3 of the flat wiring body 2 and is inwardly bent and crimped onto the rear side of the flat wiring body 2 (see FIG. 9) so that the electronic component 20 is electrically and mechanically connected to the flat wiring body 2. This electrical and mechanical connection between the flat wiring body 2 and the electronic component 20 is preferred in terms of operability and quality control since it will not generate a heat as experienced in a soldering or welding process.

It should also be noted that the lead 22 of the electronic component 20 is shear-connected to the back plate 23a of the connector 23 by a shear 23c. This shear connection is made by the shear 23c, which is formed by shearing overlapping portions of the back plate 23c of the connector 23 and the lead 22 in a parallel or substantially parallel direction such that the shear 23c is shifted relative to the surrounding portions to form a concave, as shown in FIG. 8. In this way, the lead 22 is firmly connected to the back plate 23a without the use of soldering.

As shown in FIG. 8, the shear 23c may be preformed at the overlapping portions of the lead 22 and the back plate 23a of the connector 23 before urging the piercing member 23b of the connector 23 to pierce through the flat conductor 3 of the flat wiring body 2. In the alternative, the shear 23c may be formed at overlapping portions of three members, i.e. the lead 22, the back plate 23a of the connector 23 and the flat conductor 3 of the flat wiring body 2, as shown in FIG. 9. In the former, the lead 22 of the electronic component 20 will not be shifted relative to the back plate 23a of the connector 23 when the piercing member 23b of the connector 23 is piercing into the flat conductor 3 of the flat wiring body 2. In the latter, the lead 22, the back plate 23a and the flat conductor 3 are firmly connected with one another by the shear without the use of soldering.

FIG. 10 shows a perspective view of a feed line 6 and a pierce terminal 7. The feed line 6, which is comprised of a conductor 6a and an insulating coating 6b covering the conductor 6a, serves to supply a power or signal to the electronic components mounted wiring body 10. The pierce terminal 7 is designed to provide electrical and mechanical connection between the feed line 6 and the electronic components mounted wiring body 10. As shown in FIG. 10, the pierce terminal 7 is comprised of a rear plate 7a, a piercing member 7b which is formed above the rear plate 7a from the both sides thereof (as seen in FIG. 10), a conductor crimping barrel 7d which is designed to crimp a portion of the conductor 6a where its insulating coating 6b is stripped off, and an insulating barrel 7c which is designed to crimp the feed line 6 having the insulating coating 6b. The piercing member 7b is set to pierce through a flat conductor 3 of the electronic components mounted wiring body 10 at an appropriate point thereof. The piercing member 7b is then inwardly bent on the back side of the flat wiring body 2 and crimped onto the back side so that the flat wiring body 2 of the electronic components mounted wiring body 10 is electrically and mechanically connected to the feed line 6.

With this electrical and mechanical connection between the flat wiring body 2 of the electronic components mounted wiring body 10 and the feed line 6, there is no need for stripping off the insulating coating 4 of the flat wiring body 2. In addition, this method is preferred in terms of the operability and the quality control since it will not generate a heat during making the connection, which heat is experienced in a soldering or welding process. Moreover, according to this method, any desired point of the electronic components mounted wiring body 10 can be connected to the feed line 6. A circuit separator (not shown) is provided in the electronic components mounting body 10 to configure an electric circuit for supplying power to the electronic components 20.

Fold lines or creases 50 may advantageously be preformed at bends 5 and the arrangement direction changing folds 9 of the flat wiring body 2 as shown in FIG. 11 so that the flat wiring body 2 can easily be bent just at predetermined positions using the fold lines even if the flat wiring body 2 is thick and hard to be bent.

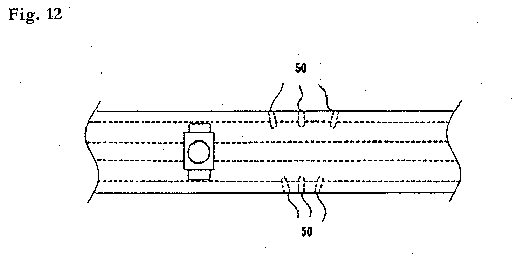

In the alternative, the fold lines 50 may extend only partially from the side edges of the flat wiring body 2 as shown in FIG. 12. Such incompletely extending fold lines 50 are effective in producing the above mentioned effect. Although the fold lines 50 are preformed on the flat wiring body 2, they may be left as they are without being used to bend the flat wiring body 2 when it is found unnecessary to bend the flat wiring body 2 for the production. Thus, the flat wiring body 2 may be preformed with a large number of the fold lines 50 so that only a subset of the fold lines is used for the production. Specifically, the flat wiring body 2 may be pre-creased with the fold lines 50 at appropriate positions where the flat wiring body 2 are expected to be bent into the bends 5 or the arrangement direction changing folds 9. The flat wiring body pre-creased in this way can flexibly be adapted to the multi-product production and the design change.

Although the present invention has been described with respect to particular embodiments thereof, it is to be understood, of course, that the scope of the present invention should not be limited thereto.

## Claims

1. An Electronic components mounted wiring body comprising:
a flat wiring body on which a plurality of electronic components is mounted;
a plurality of base members on which the flat wiring body is mounted;
wherein the flat wiring body includes an arrangement direction changing fold which is designed to change an arrangement direction of the electronic components; and
wherein each of the base members includes an arrangement direction changing member which is designed to fix the arrangement direction changing fold.

2. The electronic components mounted wiring body according to claim 1, wherein the base members are identical in shape.

3. The electronic components mounted wiring body according to claim 1, wherein the flat wiring body further includes pre-creased bends which are to be bent afterward.

4. The electronic components mounted wiring body according to one of claims 1 to 3, wherein the electronic components comprise light emitting diodes.

5. The electronic components mounted wiring body according to one of claims 1 to 4, wherein a feed line and a pierce terminal are connected to the flat wiring body at a portion thereof, in which the pierce terminal is designed to electrically and mechanically connect the feed line to the flat wiring body.

6. The electronic components mounted wiring body according to claim 1, wherein the electronic components are electrically and mechanically connected to the flat wiring body by connectors, each comprising a back plate and a piercing member.

7. The electronic components mounted wiring body according to claim 6, wherein a lead of the electronic component is connected to the back plate of the connector by shear connection.

8. The electronic components mounting structure according to one of claims 1 to 7, wherein holes are formed in the base members, and the electronic components mounted on the flat wiring body are positioned at these holes.

9. The electronic components mounted wiring body according to claim 1, wherein each of the base members further includes a fixing structure which fixes a bend of the flat wiring body.

10. An electronic components mounting structure comprising:
an electronic components mounted wiring body which comprises;
a flat wiring body on which a plurality of electronic components is mounted;
a plurality of base members on which the flat wiring body is mounted;
wherein the flat wiring body includes an arrangement direction changing fold which is designed to change an arrangement direction of the electronic components; and
wherein each of the base members includes an arrangement direction changing member which is designed to fix the arrangement direction changing fold;
wherein the electronic components mounted wiring body is assembled into a three dimensional shape by joining the plurality of the base members using joining members.
